Europäisches Patentamt

European Patent Office

Office européen des brevets

(19)

(11) **EP 0 425 611 B1**

(12) **EUROPÄISCHE PATENTSCHRIFT**

(45) Veröffentlichungstag und Bekanntmachung des Hinweises auf die Patenterteilung:
**20.08.1997 Patentblatt 1997/34**

(21) Anmeldenummer: **90906127.7**

(22) Anmeldetag: **27.04.1990**

(51) Int Cl.$^6$: **G01R 33/46**, G01R 33/48, G01R 33/56

(86) Internationale Anmeldenummer:
**PCT/DE90/00310**

(87) Internationale Veröffentlichungsnummer:
**WO 90/13827 (15.11.1990 Gazette 1990/26)**

(54) **VERFAHREN ZUR AUFNAHME VON SPINRESONANZSPEKTREN UND ZUR SPINRESONANZ-BILDGEBUNG**

A PROCESS FOR RECORDING SPIN RESONANCE SPECTRA AND DISPLAYING SPIN RESONANCE

PROCEDE D'ENREGISTREMENT DE SPECTRES DE RESONANCE MAGNETIQUE ET RESOLUTION GRAPHIQUE

(84) Benannte Vertragsstaaten:
**CH FR GB LI NL**

(30) Priorität: **29.04.1989 DE 3914301**

(43) Veröffentlichungstag der Anmeldung:
**08.05.1991 Patentblatt 1991/19**

(73) Patentinhaber: **Bruker Medizintechnik GmbH**
**D-76287 Rheinstetten (DE)**

(72) Erfinder:
- **KNÜTTEL, Alexander**
  **D-7514 Eggenstein-Leopoldshafen (DE)**
- **KIMMICH, Rainer**
  **D-7900 Ulm (DE)**

(74) Vertreter: **Witte, Alexander, Dr.-Ing. et al**
**Witte, Weller, Gahlert, Otten & Steil,**
**Patentanwälte,**
**Rotebühlstrasse 121**
**70178 Stuttgart (DE)**

(56) Entgegenhaltungen:
**EP-A- 0 385 548**         **US-A- 4 680 546**
**US-A- 4 703 270**

- **Magnetic Resonance in Medicine, Band 3, Nr. 2, April 1986, Academic Press, Inc. , (New York, US), C.L. DUMOULIN et al.: "Water Suppression in 1H Magnetic Resonance Images by the Generation of Multiple-Quantum Coherence", Seiten 282- 288**
- **Magnetic Resonance i Medicine, Band 7, Nr. 3, Juli 1988, Academic Press, Inc., (Duluth, MN, US), C.H. SOTAK: "A Volume-Localized, Two-Dimentiosnal NMR Method for the Determinaton of Lactate using Zero-Quantum Coherence Created in a Stimulated Echo Pulse Sequence", Seiten 364-370**
- **Journal of Magnetic Resonance, Band 81, Nr. 3, 15. Februar 1989, Academic Press, Inc., (Duluth, MN, US), A. KNUTTEL et al.: "Single-Scan Volumeselective Editing of 1H Signals for the Indirect Detection of Coupled X Nuclei", Seiten 570-576**
- **Magnetic Resonance in Medicine, Band 10, Nr. 3, Juni 1989, Academic Press, Inc. , (Duluth, MN, US), A. KNUTTEL et al.: "Double-Quantum Filtered Volume- Selective NMR Spectroscopy", Seiten 404-410**

**Beschreibung**

Die Erfindung betrifft ein Verfahren zur Aufnahme von Kernspinresonanzspektren von Proben mit mindestens drei Gruppen von Kernen, von denen eine erste Gruppe einer ersten Kernart mit einer zweiten Gruppe einer zweiten Kernart gekoppelt ist, während eine dritte Gruppe der ersten Kernart mit der zweiten Gruppe ungekoppelt ist, jedoch eine chemische Verschiebung aufweist, die nur mit derjenigen der ersten Gruppe im wesentlichen übereinstimmt, wobei zur alleinigen Darstellung des Signals der ersten Gruppe das Signal der dritten Gruppe unterdrückt wird.

In der Technik der Spinresonanz-Spektroskopie ist es bekannt, Spektren, bei denen Signale verschiedener Kerngruppen einander überlagern, zu "editieren". Hierunter versteht man verschiedene Aufnahmetechniken, mit denen es möglich ist, aus überlagerten Spektren Einzelsignale herauszufiltern. Üblicherweise geschieht dies, indem nacheinander mehrere Messungen mit unterschiedlichen Meßparametern ausgeführt und dann unerwünschte Signalanteile durch Differenzbildung eliminiert werden.

Beispiele derartiger Editiertechniken für Kernresonanz-Anwendungen sind in dem Lehrbuch von Sanders, Jeremy K.M. und Brian K. Hunter "Modern NMR Spectroscopy", Oxford University Press, 1987, Seiten 237 bis 259 beschrieben. Weitere derartige Verfahren sind in der EP-OS 244 752 und der EP-OS 166 559 beschrieben. Bei diesen weiteren bekannten Verfahren werden ungekoppelte Spins durch Differenzbildung zweier Messungen unterdrückt.

Die vorstehend beschriebenen Editiertechniken haben jedoch den gemeinsamen Nachteil, daß zur Aufnahme eines Spektrums mehrere, zeitlich versetzte Messungen mit unterschiedlichen Meßparametern durchgeführt werden müssen. Während dies bei langlebigen chemischen Proben in einem Labor kein wesentliches Problem darstellt, können sich erhebliche Probleme dann ergeben, wenn derartige Kernresonanzspektren an biologischen Proben, nämlich an lebendem Gewebe durchgeführt werden sollen. Dies gilt vor allem dann, wenn in-vivo-Messungen an Patienten durchgeführt werden und Bewegungsartefakte zu Meßwertverfälschungen führen können.

Differenzbildende Meßverfahren haben ferner den prinzipiellen Nachteil, daß infolge der Subtraktion von hohen Störsignalamplituden Meßfehler auftreten können, die in derselben Größenordnung liegen wie das Nutzsignal.

Es ist auch bekannt, Kernresonanzspektren volumenselektiv, d.h. nur für einen bestimmten, räumlich definierten Bereich einer Probe aufzunehmen. Diese Aufnahmetechnik hat besondere Bedeutung in der biologischen Forschung sowie der Medizin. Mit dieser Aufnahmetechnik ist es nämlich möglich, beispielsweise an einem Patienten ein Kernresonanzspektrum eines bestimmten definierten Punktes in einem inneren Organ des Patienten aufzunehmen.

Die Aufnahme von volumenselektiven Kernresonanzspektren ist eine an sich bekannte Technik, Beispiele finden sich im Lehrbuch von Wehrli, Felix W., Derek Shaw und J. Bruce Kneeland "Biomedical Magnetic Resonance Imaging", Verlag Chemie, 1988, Seiten 1 bis 45 und 521 bis 545.

Aus der US-Z "Journal of Magnetic Resonance", 67 (1986), Seite 148, ist z.B. das sogenannte SPARS-Verfahren und aus der US-Z "Journal of Magnetic Resonance", 68 (1986), Seite 367, ist das sogenannte DIGGER-Verfahren bekannt. Bei diesen bekannten Verfahren handelt es sich um volumenselektive Verfahren, bei denen die Schichten außerhalb des selektierten Volumenbereiches gesättigt werden, so daß nur noch der selektierte Volumenbereich übrig bleibt. Nachteilig bei diesen beiden bekannten Verfahren, insbesondere beim DIGGER-Verfahren, ist, daß eine hohe Hochfrequenz leistung benötigt wird, und bei beiden genannten Verfahren müssen die Vorsättigungs-Hochfrequenzpulse sehr genau eingestellt werden, weil sonst zusätzliche Signale erzeugt werden.

Ein weiteres spezielles Verfahren zur volumenselektiven Aufnahme von Kernresonanzspektren unter Verwendung von drei zeitlich beabstandeten 90°-Hochfrequenz-Impulsen bei gleichzeitigem Anliegen verschiedener Gradienten-Magnetfeld-Impulse in unterschiedlichen Koordinatenrichtungen ist auch in der DE 34 45 689 beschrieben. Bei diesem bekannten Verfahren werden herkömmliche stimulierte Spin-Echos erzeugt.

Weitere ähnliche Verfahren sind aus der US-A-4 703 270 sowie der US-Z- "Journal of Magnetic Resonance", Vol. 78, Seiten 205 bis 212; Vol. 81, Seiten 333 bis 338 sowie Vol. 60, Seiten 337 bis 341 zu entnehmen.

Wenn nun das Kernresonanzspektrum an einem homonuklear oder heteronuklear gekoppelten Spinsystem der allgemeinen Form $A_nX_m$ aufgenommen werden soll, wie dies für die biomedizinische Forschung von großem Interesse ist, weil derartige Messungen Rückschlüsse auf den Metabolismus im organischen Gewebe erlauben, so stellt sich oft das Problem der Signalüberlappung. Bei einem homonuklear gekoppelten Spinsystem bestehen beide Kopplungspartner aus derselben Kernart, z.B. aus Protonen ($^1H$), während bei heteronuklear gekoppelten Spinsystemen die Kopplungspartner zu verschiedenen Kernarten gehören, z.B. die A-Gruppe zu den Protonen ($^1H$) und die X-Gruppe zu einem Kohlenstoff-Isotop ($^{13}C$). Bei einem homonuklearen Beispielsfall von Lactat, einem $A_3X$-System, hat z.B. die Methylgruppe ($CH_3$) in etwa dieselbe chemische Verschiebung, d.h. Lage der Linie im Spektrum, wie die $CH_2$-Gruppe von Lipid, weil beide chemischen Verschiebungen ungefähr bei 1,35 ppm liegen. Da die Lipidkonzentration in lebendem Gewebe jedoch wesentlich größer sein kann, verdeckt das $CH_2$-Signal des Lipids das $CH_3$-Signal des Lactats. Entsprechendes gilt allgemein für die Editierung von heteronuklearen $A_nX_m$-Systemen, z.B. für ein $A_3X$-System wie Methanol mit $^{13}C$-Anreicherung.

Würde man nun im erstgenannten Beispielsfall eine volumenselektive Lactat-Messung in einer Lipid-Umgebung mit bekannten Editierungstechniken vornehmen, bei denen, wie erwähnt, zwei Messungen in zeitlicher Folge mit unterschiedlichen Parametern vorgenommen werden müssen, so ergäben sich Probleme dann, wenn sich der Patient während dieser beiden Messungen bewegt. Es entstehen dann nämlich Artefakte, durch die beide Messungen unterschiedlich beeinflußt werden, so daß bei einer anschließenden Differenzbildung nicht nur die gewünschten isolierten $CH_3$-Signale des Lactats, sondern auch die unerwünschten Lipid-Artefakte durch Editieren herauspräpariert werden.

Aus dem Dokument "Journal of Magnetic Resonance", Vol. 78, Seiten 355 bis 361 (1988) (Sotak, Christopher "The unequivocal determination of in vivo lactic acid using two-dimensional double-quantum coherence-transfer spectroscopy") ist ein Verfahren bekannt, bei dem an einer homonuklearen Probe Messungen mittels Doppelquanten-Kohärenztransfer vorgenommen werden. Bei diesem bekannten Verfahren wird die Tatsache ausgenutzt, daß zur Unterscheidung zwischen unterschiedlich gekoppelten Spinsystemen die Doppelquanten-Frequenz ausgenutzt werden kann, die üblicherweise für jede bestimmte Gruppe gekoppelter Spins einen eigenen Wert hat. Bei dem bekannten Verfahren wird eine Impulsfolge 90° - 180° - 90° - 90° eingesetzt. Nach jedem dieser Impulse wird ein Gradienten-Magnetfeld-Impuls eingestrahlt. Nach den beiden ersten 90°-Impulsen treten Übergänge in Nullquanten-Kohärenz bzw. Mehrquanten-Kohärenz auf, die im Zeitintervall zwischen dem zweiten und dem dritten 90°-Impuls evolvieren. Das bekannte Verfahren wird an einem homonuklearen Spinsystem $AX_3$ durchgeführt.

Aus dem Dokument EP-A1-0 385 548 (Stand der Technik gemäß Art. 54 Abs. (3) EPÜ) ist ein Verfahren der magnetischen Resonanz zur Aufnahme von selektiven Spektren bekannt. Nach diesem bekannten Verfahren werden Messungen unter anderem an Lactat vorgenommen. Es wird eine Folge von drei 90°-Hochfrequenz-Impulsen auf die Probe eingestrahlt. Die beiden ersten Impulse bewirken einen Kohärenztransfer in einen Zustand der Zwei-Quanten-Kohärenz. Der dritte Impuls bewirkt einen Kohärenztransfer in einen Zustand der Ein-Quanten-Kohärenz. Durch Verwendung zusätzlicher dephasierender Gradienten-Magnetfeld-Impulse werden zusätzlich unerwünschte Anregungen unterdrückt. Im Falle einer Zwei-Quanten-Kohärenz ist dabei die Impulsfläche des zweiten Gradienten-Magnetfeld-Impulses doppelt so groß wie die des ersten Gradienten-Magnetfeld-Impulses.

Aus dem Dokument US-A-4 680 546 sind Verfahren und Impulsfolgen zum Unterdrücken von unerwünschten Resonanzen durch Erzeugung von Quanten-Kohärenz bei der bildgebenden oder spektroskopischen Kernresonanz bekannt.

Nach diesem bekannten Verfahren wird eine N-Quanten-Kohärenz durch eine Impulsfolge von drei Hochfrequenz-Impulsen erzeugt, die beispielsweise 90°-Impulse sein können. Ferner werden zwei Gradienten-Magnetfeld-Impulse eingestrahlt und zwar der erste nach dem zweiten Hochfrequenz-Impuls und der zweite nach dem dritten Hochfrequenz-Impuls. Das Verhältnis der Impulsflächen dieser beiden Gradienten-Magnetfeld-Impulse ist gleich der Ordnung N der erzeugten Quanten-Kohärenz. Durch geeignete weitere Gradienten-Magnetfeld-Impulse, die nach dem Ende der Hochfrequenz-Impulsfolge eingestrahlt werden, können durch Repetition der Sequenz zweidimensionale Bilder erzeugt werden.

Aus dem Dokument MAGNETIC RESONANCE IN MEDICINE 7, S. 364-370 (1988) (Sotak, Christopher "A volume-localized, two-dimensional NMR method for the determination of lactate using zero-quantum coherence created in a stimulated echo pulse sequence") ist es bekannt, eine volumenselektive Spektroskopie unter Einsatz einer Hochfrequenz-Impulsfolge von drei scheibenselektiven 90°-Hochfrequenz-Impulsen einzusetzen. Auf diese Weise werden Null-Quanten-Kohärenzen und Mehrfach-Quanten-Kohärenzen erzeugt. Während der Impulsfolge werden die Kohärenzen höherer Ordnung durch Gradienten-Magnetfeld-Impulse dephasiert. Der dritte scheibenselektive 90°-Hochfrequenz-Impuls dient zum Transfer der Null-Quanten-Kohärenz in eine transversale Magnetisierung.

Der Erfindung liegt die Aufgabe zugrunde, ein Verfahren der eingangs genannten Art dahingehend weiterzubilden, daß mit einer einzigen Impulsfolge Messungen an biologischen Proben, insbesondere an Patienten, möglich sind.

Bei dem eingangs genannten Verfahren wird die der Erfindung zugrundeliegende Aufgabe dadurch gelöst,

- daß eine Impulsfolge von vier Hochfrequenz-Impulsen, vorzugsweise drei 90°-Hochfrequenz-Impulsen und einem 180°-Hochfrequenz-Impuls, auf die Probe eingestrahlt wird, wobei der erste und der dritte Hochfrequenz-Impuls auf die erste Kernart, hingegen der zweite und der vierte Hochfrequenz-Impuls auf die zweite Kernart wirken,

- daß der zweite Hochfrequenz-Impuls derart eingestellt wird, daß die Magnetisierung der Kerne der der ersten Kernart angehörenden ersten Gruppe sowie der Kerne der der zweiten Kernart angehörenden zweiten Gruppe mittels Kohärenztransfer in einen Zustand der Mehrquanten-Kohärenz überführt wird,

- daß im Zeitintervall zwischen dem zweiten Hochfrequenz-Impuls und dem vierten Hochfrequenz-Impuls ein für die Mehrquanten-Kohärenz hinsichtlich der ersten Gruppe refokussierender, dritter Hochfrequenz-Impuls auf die Probe eingestrahlt wird;

- daß im Zeitintervall zwischen dem zweiten Hochfrequenz-Impuls und dem vierten Hochfrequenz-Impuls zeitlich symmetrisch bezüglich des dritten Hochfrequenz-Impulses zwei erste Gradienten-Magnetfeld-Impulse mit gleicher, vorbestimmter Impulsfläche und gleicher oder entgegengesetzter Polarität ausgeübt werden, die zusammen die Mehrquanten-Kohärenz hinsichtlich der zweiten Gruppe oder der ersten Gruppe dephasieren,

- daß der vierte Hochfrequenz-Impuls derart eingestellt wird, daß die Mehrquanten-Kohärenz mittels Kohärenztransfer wieder in einen Zustand der Ein-Quanten-Kohärenz der Kerne der ersten Gruppe überführt wird und

- daß sodann ein für die Kerne der ersten Gruppe rephasierender, zweiter Gradienten-Magnetfeld-Impuls auf die Probe ausgeübt wird.

Durch diese Maßnahmen wird die der Erfindung zugrundeliegende Aufgabe vollkommen gelöst. Die Erfindung verwendet nämlich einen Kunstgriff, indem die Magnetisierung der interessierenden ersten Gruppe von Kernen für ein bestimmtes Zeitintervall in einen anderen Quantenzustand durch Kohärenztransfer überführt wird. Durch definierte Dephasierung der Zwei-Quanten-Kohärenz bzw. Mehrquanten-Kohärenz wird diese kodiert, um alsdann von der zweiten Gruppe durch Kohärenztransfer wieder auf die erste Gruppe übertragen und ebenso definiert rephasiert, d.h. wieder dekodiert zu werden, während in dieser Zeit das störende Signal der dritten Gruppe, das im seitherigen spektralen Bereich verblieben war, unterdrückt wird.

Auf diese Weise kann eine definierte Dephasierung mit einer vorbestimmten Impulsfläche des Gradienten-Magnetfeld-Impulses in einem Doppel- bzw. Mehrquantenzustand vorgenommen werden, und die Rephasierung kann danach ebenso definiert in dem Ein-Quanten-Zustand geschehen, wenn die Impulsfläche im Verhältnis der gyromagnetischen Verhältnisse geändert wird.

Mit anderen Worten, es wird die interessierende Information, nämlich die Magnetisierung der Kerne der ersten Gruppe, für eine kurze Zeitdauer in einen Zwei- oder Mehrquanten-Zustand verbracht und durch Dephasierung kodiert, um dann die interessierende Information zu retransferieren, während danach die interessierende erste Gruppe rephasiert (dekodiert) wird und die nicht interessierende dritte Gruppe dadurch eine Signallöschung erfährt, weil deren Spins infolge der geänderten Impulsfläche nicht rephasieren. Dies ist deswegen möglich, weil nur die interessierende erste Gruppe von Kernen mit der zweiten Gruppe gekoppelt ist und nur diese keine Signallöschung erfährt.

Hierbei sind zwei Gesichtspunkte zu berücksichtigen:

a) Gewichtung der Dephasierung über die Ordnung der Mehrquanten-Kohärenz:

In diesem Falle wird von der bekannten Tatsache ausgegangen, daß die dephasierende Wirkung eines Feldgradienten, d.h. eines Gradienten-Magnetfeld-Impulses bei einer Mehrquanten-Kohärenz um das Verhältnis der Summenfrequenz zur Einquantenfrequenz steigt. Im homonuklearen Fall bedeutet dies insbesondere, daß eine n-Quanten-Kohärenz in einem vorgegebenen Zeitintervall n-mal so stark dephasiert wie im Einquantenfall. Bei einem entsprechenden Verfahren werden demzufolge die Rephasierungs- und Dephasierungsgradienten invers gewichtet. Die Voraussetzung zur Rephasierung der nachzuweisenden Einquanten-Kohärenz ist dann, daß die Dephasierung in einem Mehrquanten-Kohärenz-Zustand erfolgt ist. Da dies nur auf die gekoppelten Spins zutreffen kann, nicht aber auf die ungekoppelten, die prinzipiell keine Mehrquanten-Kohärenzen ausbilden können, werden Signale der letzteren unterdrückt.

b) Gewichtung der Dephasierung über das gyromagnetische Verhältnis:

In diesem Falle hängt die Wirkung eines Feldgradienten auf Kohärenzen vom gyromagnetischen Verhältnis ab. Bei Mehrquanten-Kohärenzen im heteronuklearen Fall gehen die gyromagnetischen Verhältnisse aller an der Mehrquanten-Kohärenz teilnehmenden Kerne ein. Bei dieser Ausführungsform des erfindungsgemäßen Verfahrens kompensiert man nun die dephasierende Wirkung bezüglich einer Kernsorte (z.B. der Spins der ersten Gruppe A) durch einen Refokussierungsimpuls, so daß die Dephasierung im Intervall der Mehrquanten-Kohärenz nur vom gyromagnetischen Verhältnis des Heterokerns der zweiten Gruppe bestimmt wird, während die Rephasierung im nachfolgenden Intervall der Einquanten-Kohärenz entsprechend dem gyromagnetischen Verhältnis der anderen Kernsorte erfolgt. Die Gewichtung der Dephasierungs-und Rephasierungs-Feldgradienten invers zu den wirksamen gyromagnetischen Verhältnissen führt zu einer selektiven Refokussierung der heteronuklear gekoppelten Spins. Insbesondere werden Kohärenzen der ungekoppelten Spins, die prinzipiell nicht Mehrquanten-Kohärenzen ausbilden können, nicht refokussiert und damit entsprechende Signale unterdrückt.

Im Ergebnis bedeutet dies, daß das gewünschte editierte Signal bereits in einem einzigen Durchgang aufgenommen werden kann, so daß sich beispielsweise Bewegungsartefakte nicht störend auswirken können. Selbstverständlich ist es möglich, mehrere Durchgänge nacheinander aufzunehmen, um eine Erhöhung des Signal-Rauschverhältnisses in an sich bekannter Weise zu erhalten, oder zur Ausmittelung von Phasenfehlern an sich bekannte Techniken mit zyklischer Phasenverstellung anzuwenden, dies hat jedoch nichts damit zu tun, daß grundsätzlich das gesamte editierte Spektrum bereits mit einer einzigen Impulsfolge aufgenommen wird. Da, wie erwähnt, bei dem erfindungsgemäßen Verfahren die unterschiedlichen Verhältnisse hinsichtlich chemischer Verschiebung und Kopplung der ersten und dritten Gruppe von Kernen zur zweiten Gruppe ausgenutzt werden, werden die störenden Signale der dritten Gruppe auch vollkommen unterdrückt.

Im Gegensatz zu den z.B. aus der DE-OS 34 45 689 bekannten Verfahren werden bei der vorliegenden Erfindung keine herkömmlichen, stimulierten Spin-Echos, sondern vielmehr Kohärenz-Transfer-Spin-Echos erzeugt.

Bei einer bevorzugten Ausgestaltung des erfindungsgemäßen Verfahrens wird in an sich bekannter Weise zur scheiben- bzw. volumenselektiven Darstellung die Probe einer Folge von Gradienten-Magnetfeld-Impulsen unterschiedlicher Koordinatenrichtung ausgesetzt, und es werden mindestens ein bis drei der Hochfrequenz-Impulse scheibenselektiv eingestellt.

Diese Maßnahmen haben den Vorteil, daß selektive Messungen an definierten Bereichen im Inneren einer Probe, beispielsweise im Inneren eines lebendigen menschlichen Körpers, möglich sind. Es können also auf diese Weise gezielte Messungen an inneren Organen von Patienten vorgenommen werden.

Bei einer bevorzugten Weiterbildung der vorstehend genannten erfindungsgemäßen Verfahren wird vor dem Einstrahlen des ersten 90°-Hochfrequenz-Impulses ein für die Kerne bzw. Spins der zweiten Gruppe sowie für ungekoppelte Kerne bzw. Spins selektiver Hochfrequenz-Vorsättigungs-Impuls und danach ein für die Kerne bzw. Spins der zweiten Gruppe dephasierender Gradienten-Magnetfeld-Impuls auf die Probe eingestrahlt.

Diese Maßnahmen haben den Vorteil, daß störende Signale, z.B. von Wasser, unterdrückt werden, die sich hinsichtlich der chemischen Verschiebung in unmittelbarer Nähe der zweiten Gruppe befinden. Die Maßnahmen haben auf den nachfolgenden Quantentransfer und Quantenrücktransfer keinen Einfluß bzw. unterdrücken nur sowieso nicht beobachtbare Kohärenzen.

Bei einer weiteren bevorzugten Ausgestaltung des erfindungsgemäßen Verfahrens werden der erste und der zweite Gradienten-Magnetfeld-Impuls in der Zeitachse relativ zu den Hochfrequenz-Impulsen derart positioniert, daß keine stimulierten Echos ungekoppelter Spins erzeugt werden.

Diese Maßnahme hat den Vorteil, daß ein stimuliertes Echo, nämlich von unerwünschten ungekoppelten Spins, wiederum dephasiert wird, weil eine solche unerwünschte Refokussion nur bei symmetrischer Fläche, d.h. dem Produkt aus Intensität und Länge der Gradienten-Magnetfeld-Impulse zu den Hochfrequenz-Impulsen auftreten könnte.

Im übrigen ergeben sich bei dem erfindungsgemäßen Verfahren noch weitere Vorteile, beispielsweise eine Phasenunabhängigkeit aller Impulse, da jeweils vor dem zweiten und dritten 90°-Hochfrequenz-Impuls die Magnetisierung durch Gradienten-Magnetfeld-Impulse dephasiert werden kann. Ferner wirkt sich der Betrag der Hochfrequenz-Feldstärke bei den Hochfrequenz-Impulsen nicht wesentlich auf das Meßergebnis aus, sondern bewirkt allenfalls einen gewissen Signalverlust, so daß das erfindungsgemäße Verfahren auch mit Oberflächenspulen einsetzbar ist. Schließlich ist auch die Zeitdauer unkritisch, die zwischen dem ersten und dem zweiten 90°-Hochfrequenz-Impuls und zwischen dem dritten 90°-Hochfrequenz-Impuls und dem Beginn der Spektrenaufnahme eingestellt wird, weil ein Abweichen vom theoretischen Wert $1/(2J)$ beim $A_n X$-System bzw. $1/(4J)$ beim $A_n X_2$-System nur einen gewissen Signalverlust bedeuten würde, wenn die transversalen Relaxationszeiten $T_2$ sehr viel länger als die Pulssequenz sind. Bei kürzeren Relaxationszeiten $T_2$ können indes kürzere Intervalle günstiger sein.

Es versteht sich schließlich, daß weitere Vorteile erzielt werden können, wenn das erfindungsgemäße Verfahren durch weitere, an sich bekannte Maßnahmen ergänzt wird. Zu diesen Maßnahmen gehört beispielsweise die Aufnahme des vollständigen Echos in zeitlicher Symmetrie um den Punkt herum, der im zeitlichen Abstand $\tau_1$ nach dem dritten 90°-Hochfrequenz-Impuls liegt.

Ferner ist es möglich, durch Variation der Gradienten-Magnetfeld-Impulse und durch Anlegen eines Lesegradienten über dem Echo mit jeweils anschließender Fourier-Transformation in an sich bekannter Weise ein Imaging, d.h. eine bildhafte Darstellung eines zwei-oder dreidimensionalen Bereiches zu erreichen. Dabei kann infolge der verwendeten vier Impulse auch ein Ausschnitt aus einem Meßobjekt, z.B. bei einer in-vivo-Messung eines Körperorgans mit erhöhter Raumauflösung dargestellt werden. Ferner ist es möglich, einen der beiden Hochfrequenz-Impulse für die zweite Gruppe (X) hinsichtlich der chemischen Verschiebung selektiv einzustrahlen, um auf diese Weise ein hinsichtlich der chemischen Verschiebung selektives Bild zu erhalten (chemical shift imaging). Das erfindungsgemäße Verfahren läßt sich in bekannte Bildgebungsverfahren integrieren, z.B. in das 2D-FT-Verfahren mit Phasen- und Lesegradient oder in das Back-Projection-Verfahren mit Lesegradienten unter variablem Winkel oder auch in das Chemical-Shift-Imaging, d.h. die ortsaufgelöste Spektroskopie mit zwei Phasengradienten (ohne Lesegradient).

Weitere Vorteile ergeben sich aus der Beschreibung und der beigefügten Zeichnung.

Ein Ausführungsbeispiel der Erfindung ist in der Zeichnung dargestellt und wird in der nachfolgenden Beschreibung näher erläutert. Es zeigen:

Fig. 1        eine äußerst schematisierte Darstellung eines Kernresonanz-Spektrums eines homonuklear gekoppelten $A_3 X$-Systems, nämlich von Lactat ($CH_3$-CH(OH)-COOR) ;

Fig. 2        ein Schema zur Veranschaulichung von Mehrquantenübergängen am Beispiel eines AX-Systems;

| Fig. 3 | ein Impulsprogramm zur Erläuterung eines Verfahrens für ein homonuklear gekoppeltes System; |
|---|---|
| Fig. 4 | eine Darstellung einer ersten Testprobe zur Verifizierung der Eigenschaften des Verfahrens gemäß Fig. 3 ; |
| Fig. 5 bis 7 | drei an einer Probe gemäß Fig. 4 aufgenommene Kernresonanzspektren; |
| Fig. 8 | eine Darstellung, ähnlich Fig. 1, jedoch für ein heteronuklear gekoppeltes System; |
| Fig. 9A | ein Impulsprogramm zur Erläuterung eines Ausführungsbeispiels des erfindungsgemäßen Verfahrens für heteronuklear gekoppelte Systeme; |
| Fig. 9B | eine Variante zum Impulsprogramm der Fig. 9A; |
| Fig. 10 | ein Kernresonanzspektrum, das nach dem Stand der Technik an einem heteronuklear gekoppelten System aufgenommen wurde; |
| Fig. 11 | ein Kernresonanzspektrum, ähnlich Fig. 10, das jedoch nach dem erfindungsgemäßen Verfahren gemäß Fig. 9 aufgenommen wurde; |
| Fig. 12 | ein Impulsprogramm, ähnlich Fig. 9, jedoch für den Fall zwei- bzw. dreidimensionaler bildgebender Verfahren; |
| Fig. 13 | eine zweidimensionale Darstellung einer Methanol-Kugel mit natürlichem $^{13}C$-Gehalt in einer Wasserumgebung, aufgenommen mit einem bildgebenden Verfahren nach dem Stand der Technik; |
| Fig. 14 | die Darstellung der Fig. 13, jedoch mit dem bildgebenden zweidimensionalen Verfahren gemäß Fig. 12. |

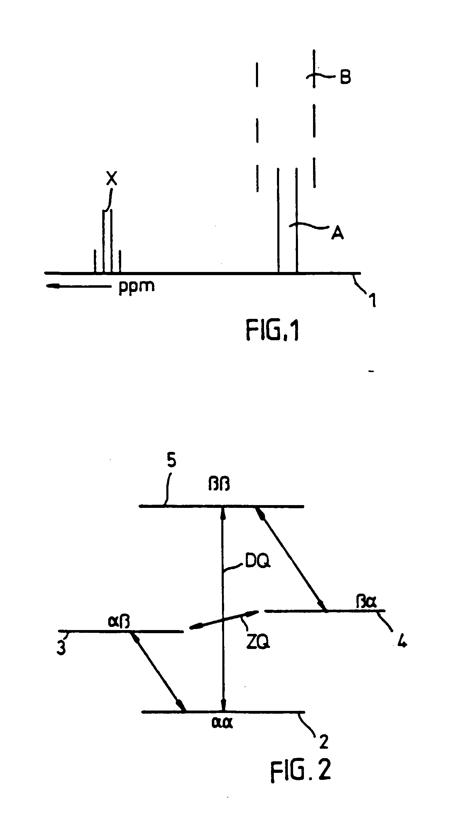

Fig. 1 zeigt in äußerst schematisierter Weise auf einer Grundlinie 1 ein Kernresonanzspektrum von Lactat, einem System, bei dem eine J-Kopplung zwischen den Protonen der $CH_3$-Gruppe (A-Linie bei 1,35 ppm) und dem Proton der CH-Gruppe (X-Linie bei 4,1 ppm) besteht. Die A-Linie der $CH_3$-Gruppe des Lactats wird dabei von der sehr viel intensiveren $\beta$-Linie der $CH_2$-Gruppe des umgebenden Lipids überdeckt, weil biologische Proben oft eine viel größere Lipidkonzentration aufweisen.

Fig. 2 zeigt in schematisierter Weise vier Energieniveaus 2, 3, 4, 5 unterschiedlicher Höhe. Das Energieniveau 2 entspricht dem Quantenzustand $\alpha\alpha$, das Energieniveau 3 dem Quantenzustand $\alpha\beta$, das Energieniveau 4 dem Quantenzustand $\beta\alpha$ und das Energieniveau 5 schließlich dem Quantenzustand $\beta\beta$. Die Ein-Quanten-Übergänge finden zwischen den Energieniveaus 2 und 3 bzw. 4 und 5 statt, was sich im Spektrum in Form eines Dubletts manifestiert.

Darüber hinaus finden aber auch Zwei-Quanten-Übergänge (DQ) unmittelbar zwischen den Energieniveaus 2 und 5 sowie Null-Quanten-Übergänge (ZQ) zwischen den Energieniveaus 3 und 4 statt. Diese Quantenübergänge DQ und ZQ sind technisch nicht beobachtbar, sie sind jedoch existent und können, wie nachstehend noch erläutert werden wird, dazu ausgenutzt werden, um verschiedene Kohärenzwege zu selektieren.

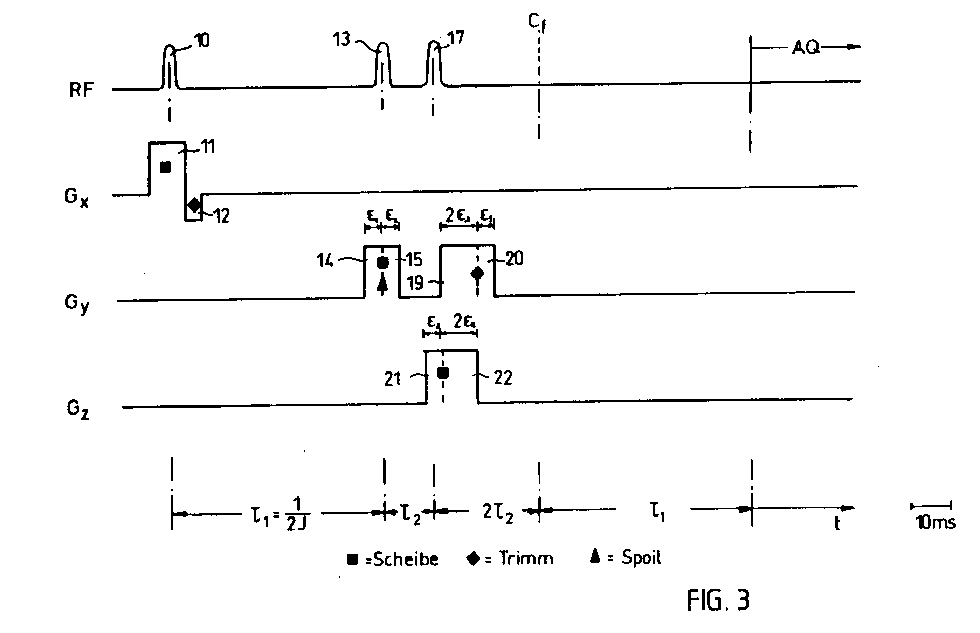

Es soll nun die A-Linie durch geeignete Editierung aus dem überlagerten Spektrum herauspräpariert werden. Hierzu dient das in Fig. 3 gezeigte Impulsprogramm. Es handelt sich hierbei nicht um ein Ausführungsbeispiel der vorliegenden Erfindung, sondern lediglich um ein Beispiel, welches das Verständnis der Erfindung erleichtert. Das Impulsprogramm dient zur Durchführung einer volumenselektiven Messung, wobei sich versteht, daß das Verfahren nicht auf volumenselektive Messungen eingeschränkt ist.

Das Impulsprogramm der Fig. 3 zeigt in der obersten Zeile Hochfrequenz-Impulse, worunter man in der Kernresonanztechnik getastete Hochfrequenz-Signale mit definierter Hüllkontur versteht. Man unterscheidet dabei zwischen sogenannten "Soft-Impulsen", d.h. Impulsen relativ langer Impulsdauer und relativ niedriger Amplitude und sogenannten "harten Impulsen" mit relativ kurzer Dauer und großer Amplitude. Außerdem unterscheidet man zwischen selektiven und nicht-selektiven Impulsen, je nachdem, ob die Hüllkurve der Impulse ein schmales oder ein breites Frequenzspektrum zur Folge hat.

In den drei mittleren Zeilen des Impulsdiagramms der Fig. 3 sind Gradienten-Magnetfeld-Impulse $G_x$, $G_y$ und $G_z$ für die drei Koordinatenrichtungen x, y und z aufgetragen. Die in Fig. 3 mit dem Symbol "■" gekennzeichneten Impulse sind dabei sogenannte "Scheibengradienten", d.h. zur Selektion einer räumlichen Scheibe dienende Gradienten-Impulse, während die mit dem Symbol "♦" gekennzeichneten Impulse sogenannte "Trimmgradienten" darstellen, d.h. den Scheibengradienten vorausgehende oder ihnen nachfolgende Gradienten, die zur Fokussierung der Kohärenz dienen.

Die mit dem Symbol "▲ " gekennzeichneten Impulse stellen schließlich sogenannte "Spoilgradienten" dar, mit denen es möglich ist, gezielt bestimmte Kohärenzen zu dephasieren oder zu rephasieren und damit deren Magnetisierung als Signal zu löschen bzw. wieder aufleben zu lassen.

Es versteht sich, daß die Gradienten-Magnetfeld-Impulse geschwindigkeits- und beschleunigungskompensiert sein können, wie dies an sich bekannt ist, z.B. aus der US-Z "Journal of Magnetic Resonance", 77 (1988), Seite 596.

Bei dem beschriebenen Verfahren kann nun zunächst, bevor die Impulsfolge der Fig. 3 einsetzt, in an sich bekannter Weise ein sogenannter Hochfrequenz-Vorsättigungsimpuls oder ein entsprechender Dephasierungsgradient, oder beides, eingesetzt werden, um die Magnetisierung der X-Gruppe und möglicher weiterer störender Signale, z.B. die von Wasser, zu löschen, damit diese für das weitere Vorgehen vernachlässigt werden kann.

Das eigentliche Verfahren beginnt indes mit einem ersten Hochfrequenz-Impuls, vorzugsweise einem 90°-Hochfrequenz-Impuls 10, der während der Wirkung eines ersten Scheibengradienten 11 mit nachfolgendem Trimmgradienten 12 in x-Richtung auf die Probe eingestrahlt wird.

Der erste 90°-Hochfrequenz-Impuls 10 ist ebenso wie die weiter unten noch zu erläuternden weiteren 90°-Hochfrequenz-Impulse ein sogenannter Softpuls, der beispielsweise eine Hüllkurve sinx/x aufweist und in Gegenwart eines Magnetfeldgradienten in x-, y- oder z-Richtung scheibenselektiv wirkt. Der erste 90°-Hochfrequenz-Impuls 10 wirkt ebenso wie die weiteren 90°-Hochfrequenz-Impulse, die weiter unten noch erläutert werden, nicht selektiv hinsichtlich der chemischen Verschiebung.

Die Pulswinkel der 90°-Hochfrequenz-Impulse sind relativ unkritisch. Prinzipiell muß der Pulswinkel nur größer als 0° sein. Beispielsweise kann der erste "90°"-Hochfrequenz-Impuls als sogenannter "ERNST"-Winkel eingestellt werden, der kleiner als 90° ist. Dieser Winkel erlaubt bei bildgebenden Messungen (Imaging) eine kurze Repetitionszeit.

Es ist ferner möglich, den ersten 900-Hochfrequenz-Impuls 10 durch eine zeitlich vorversetzte Impulsfolge aus einem 90°-Hochfrequenz-Impuls und einem für die A-Magnetisierung selektiven 130°-Hochfrequenz-Impuls zu ersetzen, um Störsignale, z.B. von Wasser, noch besser zu unterdrücken.

Infolge des ersten 90°-Hochfrequenz-Impulses 10 kippt die gesamte Magnetisierung der A- und X-Kerne in die x-y-Ebene, wobei dies für die X-Magnetisierung naturgemäß nur dann gilt, wenn diese nicht zuvor in der oben beschriebenen Weise gelöscht wurde.

Die Magnetisierung der A-Gruppe, d.h. z.B. die der Methylgruppe des Lactats ($A_3X$-System) evolviert nun unter dem Einfluß der J-Kopplung im nachfolgenden Zeitintervall $\tau_1$, wobei für ein $A_nX$-System in Abhängigkeit von der transversalen Relaxationszeit $T_2$ allgemein gilt:

$$\tau_1 = \frac{1}{\Pi\,J}\ \text{arc cot}\ \frac{1}{\Pi\,J\,T_2}$$

Für diesen Ausdruck gilt somit: $\tau_i \leq 1/(2J)$ oder ein ungeradzahliges Vielfaches davon.

Für ein $A_nX_2$-System gilt entsprechend:

$$\tau_1 = \frac{1}{2\,\Pi\,J}\ \text{arc cot}\ \frac{1}{2\,\Pi\,J\,T_2}$$

Es bildet sich nun eine Antiphasenmagnetisierung aus. Für Lactat beträgt J z.B. 7,35 Hz, so daß das Zeitintervall $\tau_1$ mit 68 ms eingestellt wird.

Nach Ablauf der Zeit $\tau_1$ wird nun ein zweiter 90°-Hochfrequenz-Impuls 13 auf die Probe eingestrahlt, während gleichzeitig in y-Richtung ein Scheibengradient 14 bzw. ein Spoilgradient 15 auf die Probe ausgeübt wird. Die Impulsfläche des Spoilgradienten 15 ist definiert groß, in Fig. 3 ist sie durch die Impulsbreite $\varepsilon_2$ gekennzeichnet.

Durch den zweiten 90°-Hochfrequenz-Impuls 13 wird die Magnetisierung der A-Gruppe - allgemeiner ausgedrückt - zu etwa 1/2 durch Polarisationstransfer, zu 1/4 in eine Doppelquanten-Kohärenz und zu einem weiteren 1/4 in eine Nullquanten-Kohärenz (bei Experimenten mit heteronuklear gekoppelten Spinsystemen: in eine Mehrquanten-Kohärenz) übertragen. Im Rahmen der in der vorliegenden Anmeldung beschriebenen Verfahren soll nur derjenige übertragene Anteil betrachtet werden, der durch Kohärenztransfer übertragen wird.

Der zweite 90°-Hochfrequenz-Impuls 13 bewirkt, das die Antiphasenmagnetisierung der A-Gruppe, und nur diese, aus ihrem Ein-Quanten-Zustand in einen Doppelquanten-Zustand durch Kohärenztransfer überführt wird, was aufgrund der J-Kopplung zwischen der A-Gruppe und der X-Gruppe (CH) bei bestimmter chemischer Verschiebung möglich ist, während die β-Magnetisierung mangels entsprechender Kopplung nicht transferiert werden kann. Die sich ergebende Doppelquanten-Kohärenz ist eine direkt nicht beobachtbare Erscheinung. Weitere Einzelheiten über die Theorie des Quantentransfers finden sich in dem genannten Buch von Sanders, aaO., Seite 121, ff.

Infolge des Doppelquanten-Zustandes evoliert die Kohärenz mit der doppelten Resonanzfrequenz. In Verbindung mit der definierten Impulslänge $\varepsilon_2$ des Spoilgradienten 15 führt dies zu einer definierten, d.h. kodierten Dephasierung der Doppelquanten-Kohärenz. Die durch die Hochfrequenz-Impulse 10 und 13 vorgegebene beliebige Phase bezüglich des dritten 90°-Hochfrequenz-Impulses 17 ist auf diesen ohne Einfluß, so daß eine Scheibenselektion in z-Richtung ermöglicht wird.

Im zeitlichen Abstand $\tau_2$ zum zweiten 90°-Hochfrequenz-Impuls 13 wird ein dritter 90°-Hochfrequenz-Impuls 17 auf die Probe eingestrahlt, der für eine Rücküberführung des Doppelquanten-Zustandes in den Ein-Quanten-Zustand der A-Gruppe sorgt. Das Zeitintervall $\tau_2$ zwischen dem zweiten Hochfrequenz-Impuls 13 und dem dritten Hochfrequenz-Impuls 17 wird dabei so kurz wie möglich eingestellt.

Die rücktransferierte Magnetisierung evolviert nun in dem anschließenden $\tau_1$-Intervall zu einer In-Phasen-Magnetisierung, die ab dem Zeitpunkt C, an dem ein Echomaximum auftritt, in einem Aufnahmeintervall AQ als freier Induktionsabfall (FID) mit bekannten Fourier-Verarbeitungsmethoden aufgenommen und dargestellt werden kann. Dabei wird vorzugsweise nur die "rechte" Seite des Echos, d.h. ab dem Zeitpunkt C, aufgenommen.

Dabei wird nach dem dritten 90°-Hochfrequenz-Impuls 17 ein Trimmgradient 19, 20 in y-Richtung und ein Scheibengradient 21, 22 in z-Richtung auf die Probe ausgeübt.

Auf diese Weise wird erreicht, daß die A-Magnetisierung durch die Spoilgradienten 19 definiert rephasiert, d.h. wieder dekodiert wird. Die Impulslänge des Trimmgradienten 19 ist mit $2\varepsilon_2$ doppelt so lang bemessen wie die Impulslänge $\varepsilon_2$ des Spoilgradienten 15. Hierdurch werden die im Ein-Quanten-Zustand jetzt wieder mit einfacher Präzessionsfrequenz umlaufenden A-Spins, und nur diese, definiert wieder rephasiert, d.h. dekodiert, während die mit $2\varepsilon_2$ in diesem Zeitintervall dephasierten B-Spins, die im Zeitintervall $\tau_2$ im Ein-Quanten-Zustand mit einfacher Präzessionsfrequenz umliefen, nunmehr nicht rephasiert werden.

Nach dem Quantenrücktransfer durch den dritten 90°-Hochfrequenz-Impuls 17 und der Rephasierung der A-Magnetisierung durch den Trimmgradienten 19 doppelter Länge $2\varepsilon_2$ ist an dieser Stelle des Spektrums somit nur noch eine meßbare Magnetisierung der A-Gruppe vorhanden, die dann in der bekannten Weise ausgewertet werden kann, während ggf. noch auftretende stimulierte Echos durch den Trimmgradienten 19 unterdrückt werden.

Man erkennt aus Fig. 3 nämlich, daß die Gradientenimpulse asymmetrisch zu den 90°-Impulsen 13 und 17 wirken, so daß keine unerwünschte Refokussierung anderer ungekoppelter Spins erfolgen kann, weil dies durch die asymmetrische Anordnung der Gradientenimpulse in beiden $\tau_1$-Intervallen verhindert wird.

Man erkennt aus Fig. 3 ferner, daß der Einfluß der chemischen Verschiebung und von Magnetfeldinhomogenitäten auf die A-Magnetisierung während der Dauer des ersten $\tau_1$-Intervalls durch die beiden 90°-Impulse 13 und 17, die gedanklich als 180°-Impuls zusammengefaßt werden können, im zweiten $\tau_1$-Intervall wieder rückgängig gemacht werden.

Die Wirkungsweise des in Fig. 3 gezeigten Impulsprogrammes wurde experimentell u.a. mit folgenden Versuchen verifiziert:

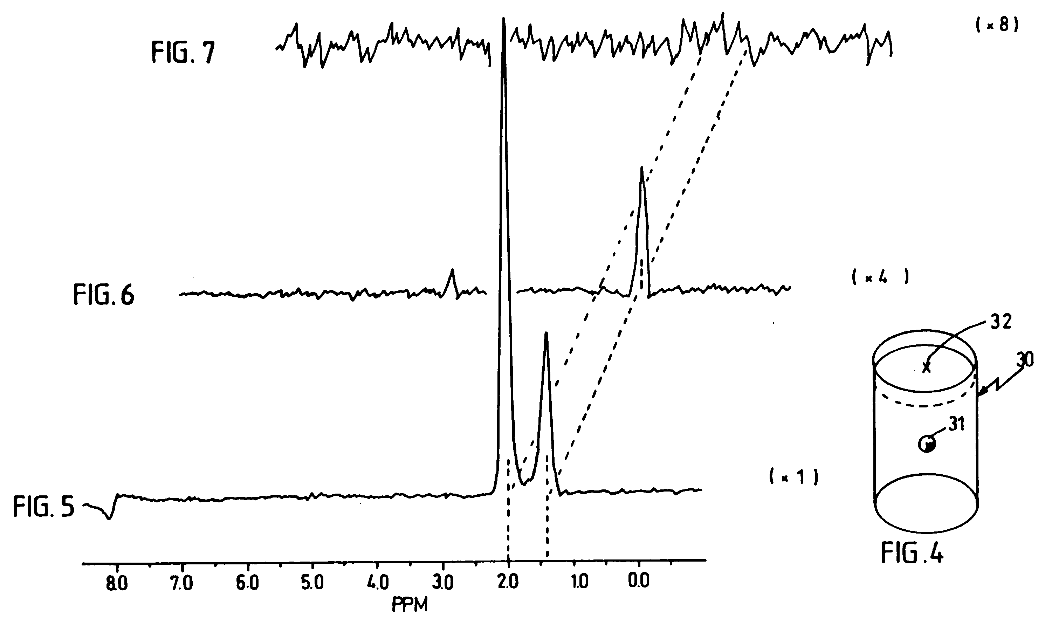

Fig. 4 zeigt schematisch eine Probe 30, bei der sich eine Kugel 31 von etwa 1 cm³ Volumen mit einer Mischung aus 50 % reinem Acetat und 50 % reinem Lactat in einer Umgebung 32 aus Wasser befindet.

Fig. 5 zeigt hierzu ein nach dem Stand der Technik aufgenommenes Spektrum mit einer Aufnahme, bei dem neben der Lactat-Linie bei etwa 1,35 ppm noch eine störende Acetat-Linie bei etwa 2,0 ppm auftritt. Die Messung wurde mit einer Impulsfolge ähnlich derjenigen durchgeführt, die in der US-Z "Journal of Magnetic Resonance", 72, 1987, Seite 379, beschrieben ist. Die Magnetfeldstärke betrug 4,7 T.

Fig. 6 zeigt demgegenüber eine Messung nach dem vorstehend besdinebeuen Verfahren mit einem Impulsprogramm nach Fig. 3, bei ansonsten unveränderten experimentellen Bedingungen, abgesehen von einem Skalierungsfaktor 4 bei der Signaldarstellung. Man erkennt aus Fig. 6 deutlich, daß das $CH_3$-Signal bei 1,35 ppm unter Berücksichtigung dieses Skalierungsfaktors etwa gleich hoch ist, wie beim Spektrum der Fig. 5. Die ungekoppelten Spins des Acetats sind hingegen praktisch verschwunden.

Fig. 7 zeigt eine Kontrollmessung, bei der die Volumenselektivität des Verfahrens überprüft wurde.

Bei der Messung der Fig. 7 wurde eine Probe mit einem räumlichen Aufbau gemäß Fig. 3 verwendet, jedoch bestand die Kugel 31 aus reinem Acetat während die Umgebung 32 aus reiner Milchsäure bestand.

Man erkennt aus Fig. 7 deutlich, daß die Messung selektiv arbeitet, weil lediglich der Volumenbereich der Kugel 31 gemessen wurde, bei der bei den vorstehend beschriebenen Verfahren die ungekoppelten Spins des Acetats unterdrückt werden, während kein $CH_3$-Signal der Milchsäure (Lactat) gemessen wurde, weil sich am Ort der Kugel 31, und nur dort, keine Milchsäure befindet.

Die vorstehend beschriebenen Verfahren zur Messung von Kernresonanzspektren an homonuklear gekoppelten Spinsystemen beruhen auf der folgenden Oberlegung:

Der reduzierte Gleichgewichtsdichteoperator in einem $A_nX$-System lautet in Hochtemperatur-Näherung:

$$\delta\ (O)\ =\ \sum_{k=1}^{n+1} I_{k\,z}$$

Dabei ist $I_1$, $I_2$..., $I_n$ der A-Gruppe zugeordnet, z.B. beim A3X-System (Lactat) ist dies die $CH_3$-Gruppe und $I_{n+1}$ entspricht der X-Gruppe, z.B. beim $A_3$X-System (Lactat) ist dies die CH-Gruppe.

Nach dem ersten 90°-Hochfrequenz-Impuls 10 (x-Phase) gilt für den Gleichgewichtsdichteoperator, wobei der Einfachheit halber $I_{n+1}$, d.h. die X-Gruppe, weggesättigt ist:

$$\delta\ =\ \sum_{k=1}^{n}\ -\ I_{k\,y}$$

Nach dem ersten Evolutionsintervall $\tau_1 = 1/(2J)$ ergibt sich einschließlich der Dephasierungsgradienten, welche den Spins eine ortsabhängige Phase $\Phi$ aufprägen (diese sei sehr viel größer als die chemische Verschiebung, so daß diese vernachlässigbar ist) :

$$\delta\ =\ \sum_{k=1}^{n}\left[2\ I_{k\,x}\ I_{(n+1)\,z}\ \cos\ \Phi_1\ +\ 2\ I_{k\,y}\ I_{(n+1)\,z}\ \sin\ \Phi_1\ \right]$$

Kompliziertere zusätzlich auftretende Terme können dabei vernachlässigt werden, weil diese praktisch nicht beobachtbar sind, bzw. durch eine zusätzliche Vorsättigung der X-Gruppe (bzw. von Wasser) erst gar nicht auftreten.

Der zweite 90°-Hochfrequenz-Impuls 13, der eine y-Phase aber auch eine beliebige andere Phase haben kann, bewirkt den Doppelquantentransfer, d.h. den Transfer der A-Magnetisierung auf eine unbeobachtbare Zwei-Quanten-Kohärenz, Die Null-Quanten-Kohärenz wird dabei durch Gradienten weggespoilt. Es gilt nun:

$$\delta\ =\ \sum_{k=1}^{n}\ -\ \frac{1}{2}\ \left[2\ I_{k\,x}\ I_{(n+1)\,y}\ +\ 2\ I_{k\,y}\ I_{(n+1)\,x}\right]\ \cos\Phi_1$$

Nach den Dephasierungsgradienten 14, 15 im Zeitintervall $\tau_2$ gilt:

$$\delta\ =\ -\ \frac{1}{2}\ \sum_{k=1}^{n}\ \left[2\ I_{k\,x}\ I_{(n+1)\,y}\ +\ 2\ I_{k\,y}\ I_{(n+1)\,x}\right]\ \cos\Phi_1\ \cos\ (2\Phi_2)$$

Terme, die zum Signal nichts beitragen, sind in dieser Formel weggelassen.

Der dritte 90°-Hochfrequenz-Impuls 17 (x-Phase) bewirkt nun einen Doppelquantenrücktransfer der X-Magnetisierung in eine beobachtbare Antiphasen-A-Magnetisierung:

$$\delta = -\frac{1}{2} \sum_{k=1}^{n} 2\, I_{kx}\, I_{(n+1)z}\, \cos \Phi_1\, \cos(2\Phi_2)$$

Im letzten $\tau_1$-Intervall (wobei weiter gilt: $\tau_1 = 1/(2J)$) wird die A-Antiphasenmagnetisierung in eine In-Phasen-Magnetisierung überführt. Gleichzeitig werden die Dephasierungen in den vorangegangenen Intervallen wieder rückgängig gemacht:

$$\langle \delta \rangle = \frac{1}{\pi^2} \int_{0}^{\pi} \int_{0}^{\pi} \ldots\; d\,\Phi_1\; d(2\Phi_2)$$

mit

$$\langle \delta \rangle = \frac{1}{8}\, I_{ky}$$

woraus folgt, daß der Signalverlust etwa 1/8 gegenüber einer fiktiven Messung mit freiem Induktionsabfall (FID) eintritt.

Eine entsprechende Betrachtung läßt sich z.B. auch für Spins mit $I > \frac{1}{2}$ durchführen.

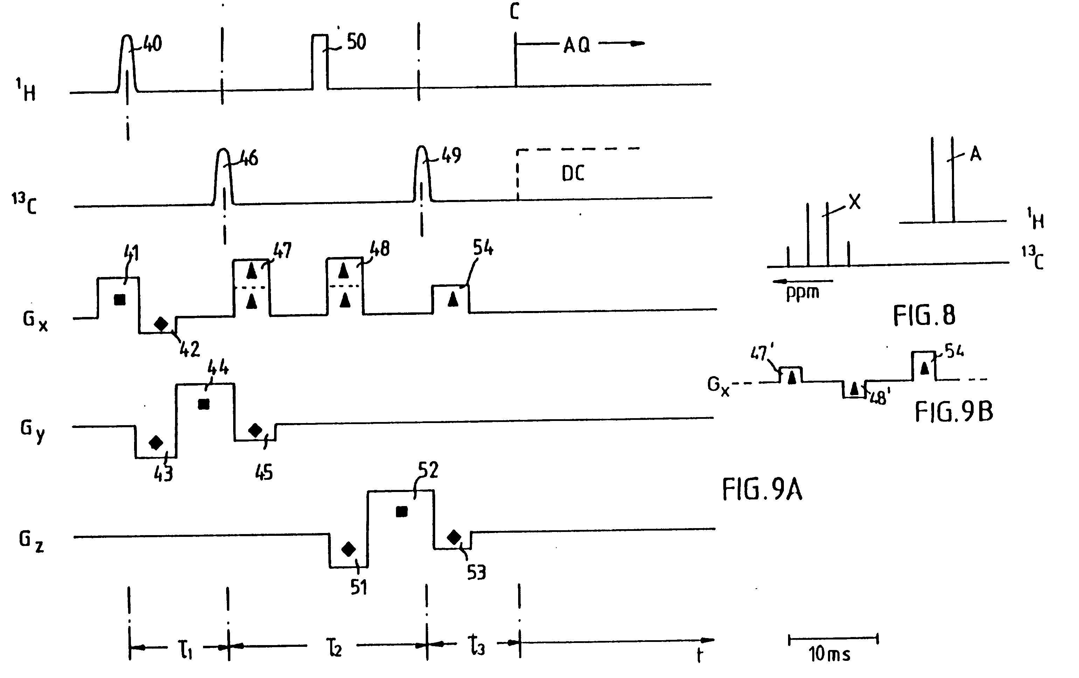

Fig. 8 zeigt in einer Darstellung ähnlich Fig. 1 ein heteronuklear gekoppeltes System. Ein solches heteronuklear gekoppeltes Spinsystem kann z.B. das Spinsystem von Glukose, Glykogen bzw. $^{13}C$ angereicherten natürlich vorkommenden Substanzen oder Medikamenten sein, die für die biomedizinische Forschung von großem Interesse sind. Diese Systeme erlauben nämlich Rückschlüsse auf den Metabolismus im organischen Gewebe.

Bei den vorstehend erläuterten Varianten des Verfahrens in ihrer Anwendung bei homonuklear gekoppelten Systemen spielte sich der Doppelquantentransfer und der Doppelquantenrücktransfer innerhalb derselben Kernart, nämlich typischerweise bei Protonen ab.

Im Gegensatz hierzu finden die nachstehend erläuterten erfindungsgemäßen Varianten des Verfahrens Anwendung bei heteronuklear gekoppelten Systemen, bei denen Kopplungen zwischen unterschiedlichen Kernarten, dargestellt am Beispiel von Protonen ($^1H$) und $^{13}C$ bestehen. Die Anregung und der Signalempfang auf Protonenseite liefert dabei eine maximale Signalintensität. Dabei müssen allerdings große Signalanteile von ungekoppelten Spins, wie z. B. Wasser, Fett oder bei natürlichem $^{13}C$-Vorkommen (1 %) die Hauptlinien, vollständig unterdrückt werden, um die J-gekoppelten $^{13}C$-Satelliten indirekt nachweisen zu können.

Mit der anhand der Fig. 9A beschriebenen Impulsfolge können heteronuklear gekoppelte Spinsysteme auf der Protonenseite editiert, d.h. herauspräpariert werden, während gleichzeitig die störenden gekoppelten und ungekoppelten Signale vollständig unterdrückt werden.

Die Darstellung der Fig. 9A entspricht dabei hinsichtlich der verwendeten Symbole vollständig derjenigen der Fig. 3, lediglich auf der Hochfrequenzseite wurden zwei Achsen $^1H$ und $^{13}C$ für die beiden Kernarten eingesetzt.

Die Betrachtung der Fig. 8 und 9A soll am Beispiel der $^{13}C$-angereicherten Testsubstanz Methanol, einem $A_3X$-System, vorgenommen werden, bei dem eine J-Kopplung zwischen den Protonen der $CH_3$-Gruppe (A-Linie bei 3 ppm) und dem $^{13}C$-Kern (X-Linie bei 50 ppm) besteht. Die heteronukleare J-Kopplung der biologisch interessanten Substanzen beträgt etwa, wie bei Methanol, J = 141 Hz, was nach der bereits weiter oben erläuterten Formel für das Zeitintervall $\tau_1$ einen Wert von $\tau_1 = 10{,}7$ ms für den Fall $\tau_1 = 3/(2J)$ ergibt.

Wie bereits erwähnt, wird bei dieser Verfahrensvariante das Signal, nämlich das A-Dublett auf der Protonenseite detektiert, wo aufgrund der dort vorhandenen drei Protonen zusätzlich eine höhere Signalintensität auftritt als dies auf der $^{13}C$-Seite bei dem dort nur vorhandenen einen Kern der Fall wäre.

In Fig. 9A ist erkennbar, daß auf der Protonenseite zunächst wiederum ein Hochfrequenz-Impuls, nämlich ein 90°-Hochfrequenz-Impuls 40 eingestrahlt wird. Während der erste 90°-Hochfrequenz-Impuls 40 auf der Protonenseite eingestrahlt wird, werden in x-Richtung ein Scheibengradient 41 mit nachfolgendem Trimmgradient 42 sowie in y-Richtung eine Folge aus einem Trimmgradienten 43, einem Scheibengradienten 44 sowie einem weiteren Trimmgradienten 45 und in z-Richtung ein Trimmgradient 51, ein Scheibengradient 52 sowie ein weiterer Trimmgradient 53 geschaltet.

Ein erster Mehrquantentransfer findet dann über einen auf $^{13}$C-Seite eingestrahlten und infolge des Scheibengradienten 44 scheibenselektiven 90°-Hochfrequenz-Impuls 46 statt, während der anschließende Mehrquantenrücktransfer über einen weiteren $^{13}$C-seitigen und infolge des Scheibengradienten 52 scheibenselektiven 90°-Hochfrequenz-Impuls 49 stattfindet. Das nachfolgende Zeitintervall $\tau_3$ bis zum Echo C ist üblicherweise zeitlich ebenso lang wie das erste Zeitintervall $\tau_1$.

Auch in diesem Falle ergibt sich der Vorteil, daß die Phasenlage des Hochfrequenz-Impulses 49 beliebig gewählt werden kann, weil zuvor die Spoilgradienten 47, 48 eine Dephasierung des Mehrquanten-Zustandes bewirkt haben.

Die Erzeugung stimulierter Echos ungekoppelter Protonen wird durch asymmetrische Gradienten in dem Protonenintervall verhindert.

Fig. 9A zeigt in x-Richtung, daß im $^{13}$C-Intervall der Länge $\tau_2$ zwei Spoilgradienten 47, 48 zeitlich symmetrisch zu einem 180°-Hochfrequenz-Impuls 50 auf die Probe ausgeübt werden, wobei die beiden Spoilgradienten 47, 48 gleichpolig sind. Aufgrund des viermal kleineren gyromagnetischen Verhältnisses von $^{13}$C gegenüber Protonen müssen die Gradienten im $\tau_2$-Intervall viermal größer sein, was durch die vier Symbole "▲" angedeutet ist. Ein weiterer Spoilgradient 54 ist zeitlich nach dem dritten 90°-Hochfrequenz-Impuls 49 in x-Richtung plaziert.

Auch hier sind die wirksamen Flächen der Gradienten-Impulse 47, 48, 54 so bemessen, daß den unterschiedlichen gyromagnetischen Verhältnissen in den unterschiedlichen Quantenzuständen Rechnung getragen wird.

Der 180°-Hochfrequenz-Impuls 50, der im Hinblick auf die chemische Verschiebung selektiv wirken kann, neutralisiert zum einen die Wirkung der Spoilgradienten 47, 48 auf die Protonen, er refokussiert darüber hinaus den Einfluß der chemischen Verschiebung sowie der Magnetfeldinhomogenität, bzw. die darauf beruhende Dephasierung. Am Ende des Zeitintervalls $\tau_2$ befindet sich die Protonenseite damit exakt in einem ungestörten Zustand, der Voraussetzung für die isolierte Wiedergabe der A-Magnetisierung nach dem Mehrquantenrücktransfer ist. Dies liegt daran, daß der Mehrquantenzustand im Gegensatz zum Polarisationstransfer, der sich isoliert immer nur auf eine Kernart ($^1$H oder $^{13}$C) auswirkt, stets beide Seiten betrifft.

In Fig. 9B ist eine Variante zu dem zuvor erläuterten Impulsprogramm der Fig. 9A zu erkennen, und zwar im Hinblick auf die beiden $G_x$-Spoilgradienten 47 und 48.

Während bei der zuvor erläuterten Impulsfolge gemäß Fig. 9A dieser beiden Spoilgradienten 47 und 48 gleichpolig auf die Probe ausgeübt wurden und jeweils die doppelte Fläche des weiteren Spoilgradienten 54 hatten, ist bei der Variante gemäß Fig. 9B vorgesehen, daß die beiden Spoilgradienten 47' und 48' gegenpolig eingestellt werden und nur die halbe Fläche des weiteren Spoilgradienten 54 aufweisen.

Man macht sich hierbei die Oberlegung zunutze, daß die Spoilgradienten 47 und 48 in Zusammenwirken mit dem 180°-Impuls 50 den Sinn haben, daß durch den 180°-Impuls 50 alles wieder rephasiert werden kann, was zuvor dephasiert wurde. Wenn nun entsprechend der Variante der Fig. 9B den Spoilgradienten 47' und 48' eine unterschiedliche Polarität gegeben wird, so wirkt dies nur auf die unerwünschten, ungekoppelten Spins (des Wassers), die auf diese Weise noch besser dephasiert werden, und zwar etwa um einen Faktor 5. Die Maßnahme der unterschiedlichen Polarität wirkt sich hingegen nicht auf die gewünschten gekoppelten Spins aus, die davon nicht berührt werden.

Aufgrund der unterschiedlichen Polarität der Spoilgradienten 47' und 48' bei der Impulsfolgen-Variante der Fig. 9B ist es erforderlich, deren Fläche kleiner zu machen und zwar auf die Hälfte der Fläche des weiteren Spoilgradienten 54.

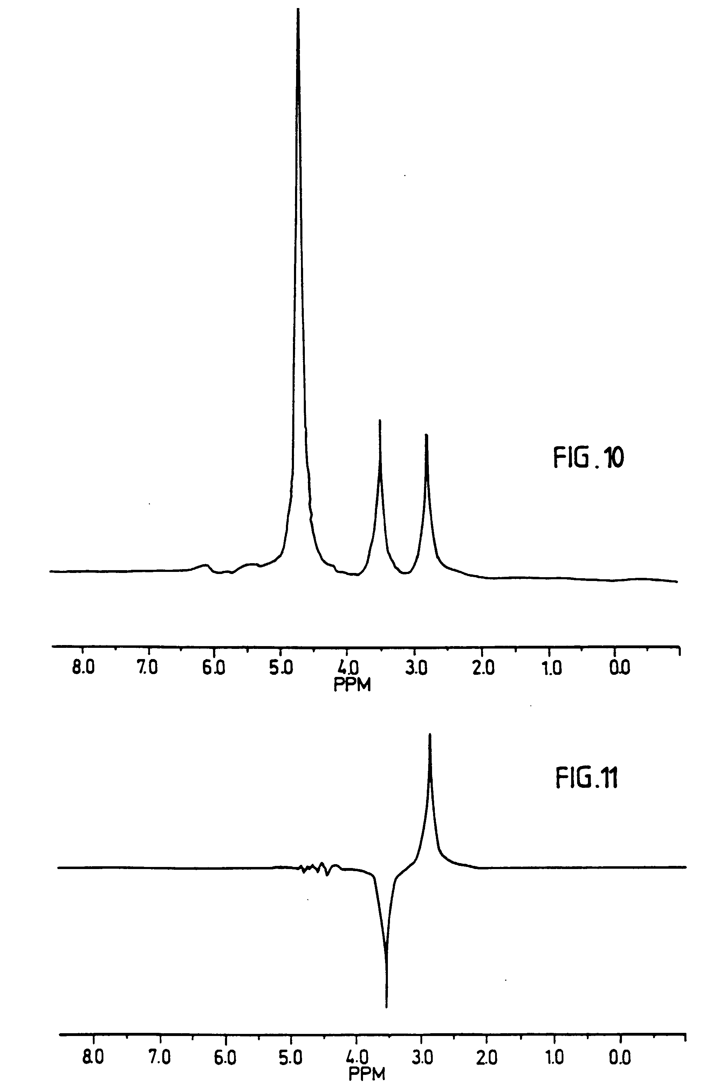

Fig. 10 zeigt ein Kernresonanzspektrum, bei dem eine Probe nach Art der Fig. 4 verwendet wurde, bei der eine von Wasser umgebene Kugel eines Volumens von einem Kubikzentimeter mit mit $^{13}$C angereichertem Methanol befüllt war. Das Kernresonanzspektrum der Fig. 10 ist mit einer nicht-editierenden Drei-Puls-Sequenz nach dem Stand der Technik bei einer Magnetfeldstärke von 4,7 T bei einem Durchlauf aufgenommen.

Demgegenüber zeigt Fig. 11 ein Kernresonanzspektrum, das mit einer Impulsfolge gemäß Fig. 9 aufgenommen wurde. Man erkennt, daß das $CH_3$-Signal bei 3 ppm etwa gleich hoch ist wie das in Fig. 10, die ungekoppelten Spins bei 4,7 ppm sind jedoch praktisch verschwunden.

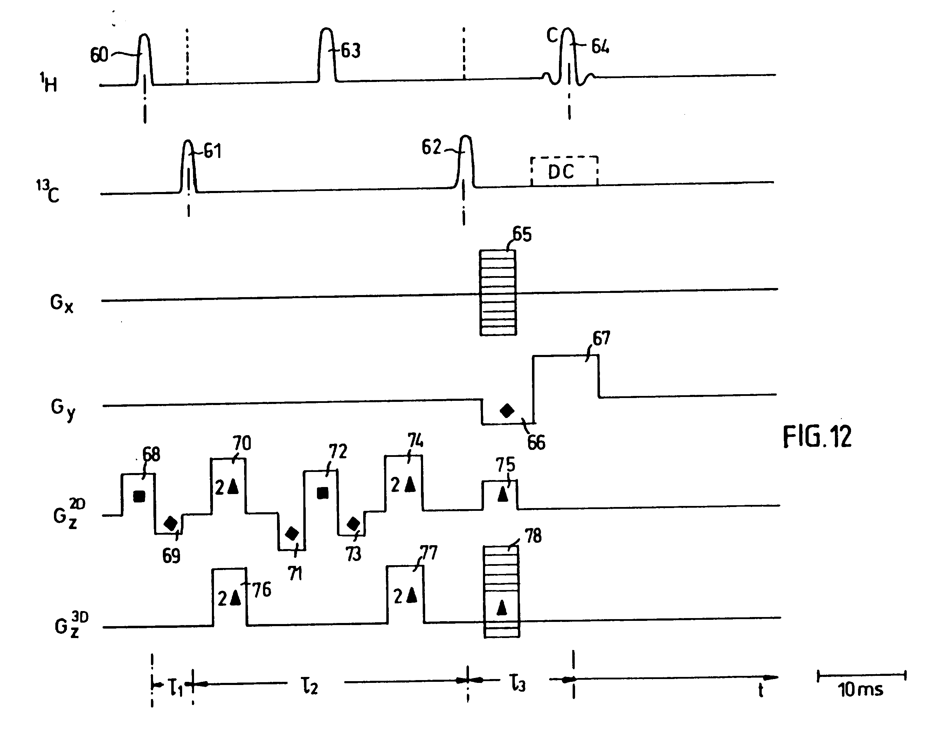

Fig. 12 zeigt ein Impulsprogramm, ähnlich dem der Fig. 9, für den Fall zwei- bzw. dreidimensionaler Bildgebung.

Auf der Hochfrequenzseite bei den Kernarten $^1$H und $^{13}$C sind die Verhältnisse unverändert, d.h. wir haben einen ersten 90°-Hochfrequenz-Impuls 60 auf Protonenseite, einen zweiten 90°-Hochfrequenz-Impuls 61 auf $^{13}$C-Seite, einen dritten 90°-Hochfrequenz-Impuls 62 wieder auf $^{13}$C-Seite und symmetrisch zu den beiden letztgenannten Impulsen 61, 62, d.h. in der Mitte des $\tau_2$-Zeitintervalles einen 180°-Hochfrequenz-Impuls 63 auf Protonenseite. Bei 64 bzw. bei C ist nach dem Ablauf des Zeitintervalls $\tau_3$ das Echo zu erkennen.

In Fig. 12 ist zusätzlich auf der $^{13}$C-Achse mit DC noch angedeutet, daß bei den Experimenten der hier interessierenden Art auch eine Entkopplung vorgenommen werden kann.

Auf der x-Achse ist ein Phasengradient 65 zu erkennen, während auf der y-Achse ein Trimmgradient 66 und ein Lesegradient 67 zu erkennen sind.

In z-Richtung wird in Fig. 12 zwischen den Fällen einer zweidimensionalen Bildgebung mit $Gz^{2D}$ bzw. $Gz^{3D}$ für den Fall der dreidimensionalen Bildgebung differenziert.

Im Falle der zweidimensionalen Bildgebung wird in z-Richtung eine Folge von Scheiben-, Trimm- und Spoilgradienten 68 bis 75 geschaltet, wie dies mit den entsprechenden Symbolen (vgl. Legende in Fig. 3) in Fig. 12 angegeben ist.

Im Falle der dreidimensionalen Bildgebung sind in z-Richtung zwei Spoilgradienten 76 und 77 sowie ein zusätzlicher Phasengradient 78 vorgesehen.

Die in z-Richtung geschalteten Gradienten ersetzen bei dem Impulsprogramm der Fig. 12 die $G_x$-Funktion, wie sie in Fig. 9 beschrieben wurde. Nun findet im Falle $Gz^{2D}$ eine zweidimensionale und im Falle $Gz^{3D}$ eine dreidimensionale Bildgebung statt, indem entsprechend vielfach Fourier-transformiert wird, wie dies an sich bekannt ist.

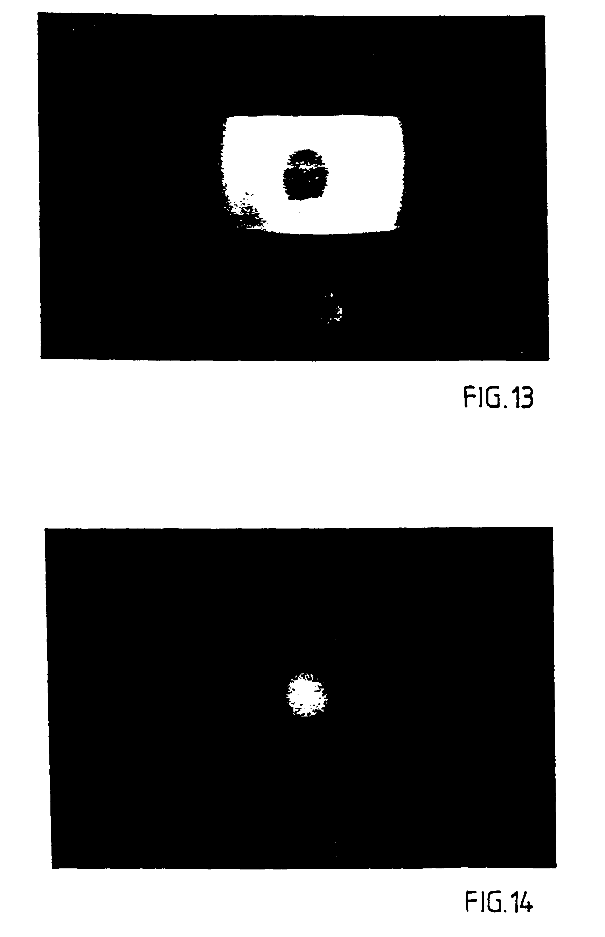

Fig. 13 und 14 zeigen die Auswirkung des erfindungsgemäßen bildgebenden Verfahrens. Fig. 13 zeigt eine herkömmliche Darstellung einer Kugel aus reinem Methanol mit natürlichem $^{13}$C-Gehalt in einer Wasserumgebung. Die Wasserumgebung ist als Rechteck deutlich erkennbar. Fig. 14 zeigt demgegenüber eine Messung an demselben Objekt, jedoch mit dem editierenden zweidimensionalen Verfahren gemäß Fig. 12, und man erkennt deutlich, daß die Wasserumgebung unterdrückt ist.

## Patentansprüche

1. Verfahren zur Aufnahme von Kernspinresonanzspektren von Proben mit mindestens drei Gruppen (A, B, X) von Kernen, von denen eine erste Gruppe (A) einer ersten Kernart ($^1$H) mit einer zweiten Gruppe (X) einer zweiten Kernart ($^{13}$C) gekoppelt ist, während eine dritte Gruppe (B) der ersten Kernart ($^1$H) mit der zweiten Gruppe (X) ungekoppelt ist, jedoch eine chemische Verschiebung aufweist, die nur mit derjenigen der ersten Gruppe (A) im wesentlichen übereinstimmt, wobei zur alleinigen Darstellung des Signals der ersten Gruppe (A) das Signal der dritten Gruppe (B) unterdrückt wird, dadurch gekennzeichnet,

   - daß eine Impulsfolge von vier Hochfrequenz-Impulsen (40, 46, 50, 49; 60, 61, 63, 62), vorzugsweise drei 90°-Hochfrequenz-Impulsen (40, 46, 49; 60, 61, 62) und einem 180°-Hochfrequenz-Impuls (50; 63), auf die Probe eingestrahlt wird, wobei der erste (40; 60) und der dritte (50; 63) Hochfrequenz-Impuls auf die erste Kernart ($^1$H), hingegen der zweite (46; 61) und der vierte (49; 62) Hochfrequenz-Impuls auf die zweite Kernart ($^{13}$C) wirken,

   - daß der zweite Hochfrequenz-Impuls (46; 61) derart eingestellt wird, daß die Magnetisierung der Kerne der der ersten Kernart ($^1$H) angehörenden ersten Gruppe (A) sowie der Kerne der der zweiten Kernart ($^{13}$C) angehörenden zweiten Gruppe (X) mittels Kohärenztransfer in einen Zustand der Mehrquanten-Kohärenz überführt wird,

   - daß im Zeitintervall ($\tau_2$) zwischen dem zweiten Hochfrequenz-Impuls (46; 61) und dem vierten Hochfrequenz-Impuls (49; 62) ein für die Mehrquanten-Kohärenz hinsichtlich der ersten Gruppe (A) refokussierender, dritter Hochfrequenz-Impuls (50; 63) auf die Probe eingestrahlt wird;

   - daß im Zeitintervall ($\tau_2$) zwischen dem zweiten Hochfrequenz-Impuls (46; 61) und dem vierten Hochfrequenz-Impuls (49; 62) zeitlich symmetrisch bezüglich des dritten Hochfrequenz-Impulses (50; 63) zwei erste Gradienten-Magnetfeld-Impulse mit gleicher, vorbestimmter Impulsfläche und gleicher oder entgegengesetzter Polarität ausgeübt werden, die zusammen die Mehrquanten-Kohärenz hinsichtlich der zweiten Gruppe (X) oder der ersten Gruppe (A) dephasieren,

   - daß der vierte Hochfrequenz-Impuls (49; 62) derart eingestellt wird, daß die Mehrquanten-Kohärenz mittels Kohärenztransfer wieder in einen Zustand der Ein-Quanten-Kohärenz der Kerne der ersten Gruppe (A) überführt wird, und

   - daß sodann ein für die Kerne der ersten Gruppe (A) rephasierender, zweiter Gradienten-Magnetfeld-Impuls (54; 75) auf die Probe ausgeübt wird.

2. Verfahren nach Anspruch 1, dadurch gekennzeichnet, daß für den Fall gleicher Polarität der beiden ersten Gradienten-Magnetfeld-Impulse die Impulsfläche des zweiten Gradienten-Magnetfeld-Impulses (54; 75) das k-fache der Summe der Impulsfläche der beiden ersten Gradienten-Magnetfeld-Impulse (47, 48; 70, 74) beträgt, wobei k der Quotient der gyromagnetischen Verhältnisse der Kerne der beiden Kernarten ist.

3. Verfahren nach Anspruch 1, dadurch gekennzeichnet, daß für den Fall entgegengesetzter Polarität der beiden ersten Gradienten-Magnetfeld-Impulse die Impulsfläche des zweiten Gradienten-Magnetfeld-Impulses (54) das Zweifache der Impulsfläche jedes der beiden ersten Gradienten-Magnetfeld-Impulse (47', 48') beträgt.

4. Verfahren nach einem der Ansprüche 1 bis 3, dadurch gekennzeichnet, daß in an sich bekannter Weise zur scheiben-bzw. volumenselektiven Darstellung die Probe (30) einer Folge von Gradienten-Magnetfeld-Impulsen (41 bis 45, 51 bis 53; 68,69,71-73) unterschiedlicher Koordinatenrichtung (x, y, z) ausgesetzt wird, und daß mindestens ein bis drei der Hochfrequenz-Impulse (40, 46, 49; 60, 63) scheibenselektiv eingestellt werden.

5. Verfahren nach einem der Ansprüche 1 bis 4, dadurch gekennzeichnet, daß vor dem Einstrahlen des ersten Hochfrequenz-Impulses (40; 60) ein für die Kerne bzw. Spins der zweiten Gruppe (X) sowie für ungekoppelte Kerne ($H_2O$) bzw. Spins selektiver Hochfrequenz-Vorsättigungs-Impuls und danach ein für die Kerne bzw. Spins der zweiten Gruppe (X) dephasierender Gradienten-Magnetfeld-Impuls auf die Probe (30) eingestrahlt wird.

6. Verfahren nach einem der Ansprüche 1 bis 5, dadurch gekennzeichnet, daß der erste und der zweite Gradienten-Magnetfeld-Impuls (47/48, 54) in der Zeitachse (t) relativ zu den Hochfrequenz-Impulsen (46, 49) derart positioniert werden, daß keine stimulierten Echos ungekoppelter Spins erzeugt werden.

7. Verfahren nach einem der Ansprüche 1 bis 6, dadurch gekennzeichnet, daß das Zeitintervall ($\tau_1$) zwischen dem ersten Hochfrequenz-Impuls (40; 60) und dem zweiten Hochfrequenz-Impuls (46; 61) gleich einem ungeradzahligen Vielfachen des Kehrwertes des Zweifachen der Kopplungskonstanten (J) zwischen der ersten Gruppe (A) und der zweiten Gruppe (X) bemessen wird.

8. Verfahren nach einem der Ansprüche 1 bis 6, dadurch gekennzeichnet, daß für ein $A_nX$-System das Zeitintervall ($\tau_1$) zwischen dem ersten Hochfrequenz-Impuls (40; 60) und dem zweiten Hochfrequenz-Impuls (46; 61) nach der Formel

$$\tau_1 = \frac{1}{\pi\,J}\,\text{arc cot}\,\frac{1}{\pi\,J\,T_2}$$

bemessen wird, wobei J die Kopplungskonstante zwischen der ersten Gruppe (A) und der zweiten Gruppe (X) und $T_2$ die transversale Relaxationszeit ist.

9. Verfahren nach einem der Ansprüche 1 bis 6, dadurch gekennzeichnet, daß für ein $A_nX_2$-System das Zeitintervall ($\tau_1$) zwischen dem ersten Hochfrequenz-Impuls (40; 60) und dem zweiten Hochfrequenz-Impuls (46; 61) nach der Formel

$$\tau_1 = \frac{1}{2\,\pi\,J}\,\text{arc cot}\,\frac{1}{2\,\pi\,J\,T_2}$$

bemessen wird, wobei J die Kopplungskonstante zwischen der ersten Gruppe (A) und der zweiten Gruppe (X) und $T_2$ die transversale Relaxationszeit ist.

10. Verfahren nach einem der Ansprüche 4 bis 9, dadurch gekennzeichnet, daß in an sich bekannter Weise eine bildgebende Darstellung der Probe (30) durchgeführt wird.

11. Verfahren nach einem der Ansprüche 4 bis 10, dadurch gekennzeichnet, daß zur Darstellung eines Ausschnittes aus einem Meßobjekt gleichzeitig mit dem Aussenden eines der für die Kerne der zweiten Kernart ($^{13}$C) einge-strahlten Hochfrequenz-Impulses (61, 62) ein Gradienten-Magnetfeld-Impuls angelegt wird.

12. Verfahren nach einem der Ansprüche 4 bis 11, dadurch gekennzeichnet, daß einer der für die Kerne der zweiten Kernart ($^{13}$C) eingestrahlten Hochfrequenz-Impulse (61, 62) hinsichtlich der chemischen Verschiebung selektiv eingestellt ist.

## EP 0 425 611 B1

### Claims

1.  A method of recording nuclear spin resonance spectra of samples having at least three groups (A, B, X) of nuclei, a first group (A) of which of a first kind of nuclei ($^1$H) being coupled with a second group (X) of a second kind of nuclei ($^{13}$C), whereas a third group (B) of the first kind of nuclei ($^1$H) is non-coupled with the second group (X) but has, however, a chemical shift coinciding essentially with that of the first group (A) only, wherein for the exclusive displaying of the signal of the first group (A) the signal of the third group (B) is suppressed, characterized in that

    -   a pulse sequence of four high frequency pulses (40, 46, 50, 49; 60, 61, 63, 62), preferably of three 90° high frequency pulses (40, 46, 49; 60, 61, 62) and one 180° high frequency pulse (50; 63), is irradiated on the sample, wherein the first (40; 60) and the third (50; 63) high frequency pulse act on the first kind of nuclei ($^1$H) whereas the second (46; 61) and the fourth (49; 62) high frequency pulse act on the second kind of nuclei ($^{13}$C),

    -   the second high frequency pulse (46; 61) is set such that the magnetization of the nuclei of the first group (A) belonging to the first kind of nuclei ($^1$H) as well as the nuclei of the second group (X) belonging to the second kind of nuclei ($^{13}$C) are transferred into a state of multiple quantum coherence by means of coherence transfer,

    -   during the time interval ($\tau_2$) between the second high frequency pulse (46; 61) and the fourth high frequency pulse (49; 62) a third high frequency pulse (50; 63), is irradiated on the sample, the third high frequency pulse (50; 63) being refocussing with respect to the first group (A),

    -   during the time interval ($\tau_2$) between the second high frequency pulse (46; 61) and the fourth high frequency pulse (49; 62) two first gradient magnetic field pulses are exerted, said two first gradient magnetic field pulses having an equal and predetermined pulse area, having, further, an equal or opposite polarity, being symmetric in timing with respect to the third high frequency pulse (50; 63), and jointly dephasing the multiple quantum coherence with respect to the second group (X) or to the first group (A),

    -   the fourth high frequency pulse (49; 62) is set such that the multiple quantum coherence is again transferred into a state of single quantum coherence of the nuclei of the first group (A) by means of coherence transfer, and

    -   subsequently a second gradient magnetic field pulse (54; 75) is exerted on the sample, said second gradient magnetic field pulse (54; 75) being rephasing for the nuclei of the first group (A).

2.  The method of claim 1, characterized in that in the case of equal polarity of the two first gradient magnetic field pulses the pulse area of the second gradient magnetic field pulse (54; 75) is k-times the sum of the pulse area of the two first gradient magnetic field pulses (47, 48; 70, 74), k being the ratio of the gyromagnetic ratios of the nuclei of the two kinds of nuclei.

3.  The method of claim 1, characterized in that in the case of opposite polarity of the two first gradient magnetic field pulses the pulse area of the second gradient magnetic field pulse (54) is two times the pulse area of each of the two first gradient magnetic field pulses (47', 48').

4.  The method of any of claims 1 through 3, characterized in that the sample (30) is exposed to a sequence of gradient magnetic field pulses (41 to 45, 51 to 53; 68, 69, 71 to 73) of different coordinate direction (x, y, z), at least one to three of the high frequency pulses (40, 46, 49; 60, 63) being set to be slice-selective, for effecting a slice-selective or a volume-selective display, respectively, as known per se.

5.  The method of any of claims 1 through 4, characterized in that prior to the irradiation of the first high frequency pulse (40; 60) a high frequency pre-saturation pulse and subsequently a gradient magnetic field pulse are irradiated on the sample (30), the high frequency pre-saturation pulse being selective for the nuclei and spins, respectively, of the second group (X) as well as for non-coupled nuclei ($H_2O$) and spins, respectively, the gradient magnetic field pulse being dephasing for the nuclei and spins, respectively, of the second group (X).

6.  The method of any of claims 1 through 5, characterized in that the first and the second gradient magnetic field pulse (47/48, 54) are positioned along the time axis (t) relative to the high frequency pulses (46, 49) such that no stimulated echoes of non-coupled spins are generated.

7.  The method of any of claims 1 through 6, characterized in that the time interval ($\tau_1$) between the first high frequency

14

pulse (40; 60) and the second high frequency pulse (46; 61) is set to be equal to the odd multiple of the reciprocal value of twice the coupling constant (J) between the first group (A) and the second group (X).

8. The method of any of clainms 1 through 6, characterized in that for an $A_nX$-system the time interval ($\tau_1$) between the first high frequency pulse (40; 60) and the second high frequency pulse (46; 61) is set according to the formula:

$$\tau_1 = \frac{1}{\pi J} \text{ arc cot } \frac{1}{\pi J T_2}$$

wherein J is the coupling constant between the first group (A) and the second group (X) and $T_2$ is the transversal relaxation time.

9. The method of any of claims 1 through 6, characterized in that for an $A_nX_2$-system the time interval ($\tau_1$) between the first high frequency pulse (40; 60) and the second high frequency pulse (46; 61) is set according to the formula:

$$\tau_1 = \frac{1}{2\pi J} \text{ arc cot } \frac{1}{2\pi J T_2}$$

wherein J is the coupling constant between the first group (A) and the second group (X) and $T_2$ is the transversal relaxation time.

10. The method of any of claims 4 through 9, characterized in that an imaging display of the sample (30) is effected, as known per se.

11. The method of any of claims 4 through 10, characterized in that a gradient magnetic field pulse is exerted together with the transmission of a high frequency pulse (61, 62) irradiated for the nuclei of the second kind of nuclei ($^{13}$C), for displaying a detail from a sample.

12. The method of any of claims 4 through 11, characterized in that a high frequency pulse (61, 62) irradiated for the nuclei of the second kind of nuclei ($^{13}$C) is set selective with respect to the chemical shift.

**Revendications**

1. Procédé d'enregistrement de spectres de résonance magnétique nucléaire de spins sur des échantillons comportant au moins trois groupes (A, B, X) de noyaux, dont un premier groupe (A) d'un premier type de noyau ($^1$H) est couplé à un second groupe (X) d'un deuxième type de noyau ($^{13}$C), tandis qu'un troisième groupe (B) du premier type de noyau ($^1$H), non couplé au second groupe (X), présente un déplacement chimique qui ne correspond sensiblement qu'à celui du premier groupe (A), le signal du troisième groupe (B) étant inhibé pour permettre la représentation exclusive du signal du premier groupe (A), <u>caractérisé</u> en ce que :

-   une séquence d'impulsions constituée par quatre impulsions haute fréquence (40, 46, 50, 49 60, 61, 63, 62), de préférence trois impulsions haute fréquence à 90° (40, 46, 49 ; 60, 61, 62) et une impulsion haute fréquence à 180° (50 ; 63), est envoyée sur l'échantillon, la première (40 ; 60) et la troisième (50 ; 63) des impulsions haute fréquence agissant sur le premier type de noyau ($^1$H), tandis que la deuxième (46 ; 61) et la quatrième (49 ; 62) des impulsions haute fréquence agissent sur le deuxième type de noyau ($^{13}$C),

-   la deuxième impulsion haute fréquence (46 ; 61) est réglée de telle sorte que la magnétisation des noyaux du premier groupe (A) appartenant au premier type de noyau ($^1$H), ainsi que celle des noyaux du deuxième groupe (X) appartenant au deuxième type de noyau ($^{13}$C), soient transposées, au moyen d'un transfert de cohérence, dans un état de cohérence de quanta multiples,

-   dans l'intervalle de temps ($\tau_2$) entre la deuxième impulsion haute fréquence (46 ; 61) et la quatrième impulsion haute fréquence (49 ; 62), une troisième impulsion haute fréquence (50 ; 63) de refocalisation de la cohérence de quanta multiples relative au premier groupe (A), est envoyée sur l'échantillon ;

- dans l'intervalle de temps ($\tau_2$) entre la deuxième impulsion haute fréquence (46 ; 61) et la quatrième impulsion haute fréquence (49 ; 62), sont appliquées symétriquement dans le temps par rapport à la troisième impulsion haute fréquence (50 ; 63), deux premières impulsions de champ magnétique à gradients ayant une même surface d'impulsion prédéfinie, de même polarité ou de polarité inverse, qui déphasent ensemble la cohérence de quanta multiples relative au deuxième groupe (X) ou au premier groupe (A),

- la quatrième impulsion haute fréquence (49 ; 62) est appliquée de telle sorte que la cohérence de quanta multiples soit, par transfert de cohérence, retransposée dans un état de cohérence de quanta simples des noyaux du premier groupe (A), et

- une seconde impulsion de champ magnétique à gradients (54 ; 75) est ensuite appliquée sur l'échantillon pour remettre en phase les noyaux du premier groupe (A).

2. Procédé selon la revendication 1, caractérisé en ce que dans le cas où les deux premières impulsions de champ magnétique à gradients sont de même polarité, la surface d'impulsion de la seconde impulsion de champ magnétique à gradients (54 ; 75) est égale à k fois la somme des surfaces d'impulsion des deux premières impulsions de champ magnétique à gradients (47, 48 ; 70, 74), k étant le quotient des taux gyromagnétiques des noyaux des deux types de noyau.

3. Procédé selon la revendication 1, caractérisé en ce que dans le cas où les deux premières impulsions de champ magnétique à gradients sont de polarité inverse, la surface d'impulsion de la seconde impulsion de champ magnétique à gradients (54) est égale au double de la surface d'impulsion de chacune des deux premières impulsions de champ magnétique à gradients (47', 48').

4. Procédé selon l'une quelconque des revendications 1 à 3, caractérisé en ce que, pour la représentation à sélection de tranche ou à sélection de volume, l'échantillon (30) est soumis, de façon connue, à une séquence d'impulsions de champ magnétique à gradients (41 à 45, 51 à 53 ; 68 ; 69 ; 71 à 73) selon différents axes de coordonnées (x, y, z), et en ce qu'au moins une à trois des impulsions haute fréquence (40, 46, 49 ; 60, 63) sont réglées de façon à être à sélection de tranche.

5. Procédé selon l'une quelconque des revendications 1 à 4, caractérisé en ce qu'avant l'application de la première impulsion haute fréquence (40 ; 60), l'échantillon (30) est soumis à une impulsion haute fréquence de présaturation sélective pour les noyaux ou les spins du deuxième groupe (X) et pour les noyaux ou les spins non couplés ($H_2O$), suivie d'une impulsion de champ magnétique à gradients déphasante pour les noyaux ou les spins du deuxième groupe (X).

6. Procédé selon l'une quelconque des revendications 1 à 5, caractérisé en ce que la première et la seconde des impulsions de champ magnétique à gradients (47/48, 54) peuvent être positionnées sur l'axe des temps (t), par rapport aux impulsions haute fréquence (46, 49), de telle sorte qu'aucun écho stimulé de spins non couplés ne se produise.

7. Procédé selon l'une quelconque des revendications 1 à 6, caractérisé en ce que la valeur mesurée de l'intervalle de temps ($\tau_1$) entre la première impulsion haute fréquence (40 ; 60) et la deuxième impulsion haute fréquence (46 ; 61) est égale à un multiple impair de l'inverse du double de la constante de couplage (J) entre le premier groupe (A) et le deuxième groupe (X).

8. Procédé selon l'une quelconque des revendications 1 à 6, caractérisé en ce que, pour un système $A_nX$, la valeur de l'intervalle de temps ($\tau_1$) entre la première impulsion haute fréquence (40 ; 60) et la deuxième impulsion haute fréquence (46 ; 61), est mesurée conformément à la formule suivante :

$$\tau_1 = \frac{1}{\pi\, J} \, \text{arc cot} \, \frac{1}{\pi\, J\, T_2}$$

dans laquelle J est la constante de couplage entre le premier groupe (A) et le deuxième groupe (X) et $T_2$, le temps de relaxation transversale.

9. Procédé selon l'une quelconque des revendications 1 à 6, caractérisé en ce que, pour un système $A_nX_2$, la valeur

de l'intervalle de temps ($\tau_1$) entre la première impulsion haute fréquence (40 ; 60) et la deuxième impulsion haute fréquence (46 ; 61) est mesurée conformément à la formule suivante :

$$\tau_1 = \frac{1}{2\,\pi\,J}\,\text{arc cot}\,\frac{1}{2\,\pi\,J\,T_2}$$

dans laquelle J est la constante de couplage entre le premier groupe (A) et le deuxième groupe (X), et $T_2$, le temps de relaxation transversale.

10. Procédé selon l'une quelconque des revendications 4 à 9, caractérisé en ce qu'une représentation imagée de l'échantillon est obtenue de façon connue.

11. Procédé selon l'une quelconque des revendications 4 à 10, caractérisé en ce que, pour la représentation partielle d'un objet à mesurer, en même temps qu'une impulsion haute fréquence (61, 62) est envoyée pour les noyaux du deuxième type de noyau ($^{13}$C), une impulsion de champ magnétique à gradients est appliquée.

12. Procédé selon l'une quelconque des revendications 4 à 11, caractérisé en ce que l'une des impulsions haute fréquence (61, 62) envoyées pour les noyaux du deuxième type de noyau ($^{13}$C) est réglée de façon à être sélective en ce qui concerne le déplacement chimique.

FIG.1

FIG.2

FIG. 3

10 ms

RF

$G_x$

$G_y$

$G_z$

AQ

$C_f$

10

11

12

13

17

14

15

19

20

21

22

$\varepsilon_1 \varepsilon_2$

$2\varepsilon_2 \varepsilon_1$

$\varepsilon_1 \, 2\varepsilon_2$

$\tau_1 = \frac{1}{2J}$

$\tau_2$

$2\tau_2$

$\tau_1$

t

■ = Scheibe   ◆ = Trimm   ▲ = Spoil

FIG. 7  ( × 8 )

FIG. 6  ( × 4 )

FIG. 5  ( × 1 )

8.0  7.0  6.0  5.0  4.0  3.0  2.0  1.0  0.0

PPM

FIG. 4

32

30

31

EP 0 425 611 B1

EP 0 425 611 B1

$^1$H

40

50

C

AQ

$^{13}$C

46

49

DC

A

X

$^1$H

$^{13}$C

ppm

FIG.8

$G_x$

41

47

48

54

42

47'

54

$G_x$

48'

FIG.9B

44

$G_y$

43

45

FIG.9A

52

$G_z$

51

53

$T_1$  $T_2$  $t_3$  t

10ms

FIG.10

FIG.11

FIG.12

FIG.13

FIG.14